# EUROPEAN PATENT APPLICATION

(11) **EP 4 764 544 A1**
(43) Date of publication of application: **24.06.2026**
(21) Application number: 25774828.5
(22) Date of filing: 16.01.2025
(51) Int. Cl.: G01R 31/392, G01R 31/367, G01R 31/396, G01R 31/3842, H01M 10/052

(54) **BATTERY DIAGNOSTIC DEVICE AND OPERATION METHOD THEREOF**

(30) Priority: 19.03.2024 KR 20240037910
(71) Applicant: LG Energy Solution, Ltd., Seoul 07335 (KR)
(72) Inventor: HWANG, Gyu Yeong, Daejeon 34122 (KR); JUN, Gwang Hoon, Daejeon 34122 (KR); KOH, Dong Wook, Daejeon 34122 (KR); LEE, Hyeon Ho, Daejeon 34122 (KR)
(74) Representative: Plasseraud IP
(86) International application number: PCT/KR2025/000959
(87) International publication number: WO 2025/198164

(57) **Abstract**

A battery diagnosis device according to an embodiment disclosed in this document may include an interface that acquires a first charge profile in the middle of life (MOL) of a battery cell, and at least one processor that predicts a second charge profile using a battery physical model representing a state of a battery and an input parameter that depends on a change in a degradation indicator corresponding to the first charge profile and calculates the degradation indicator of the battery cell corresponding to each of the first charge profile and the second charge profile.

## Description

### CROSS-REFERENCE TO RELATED APPLICATION

The present application claims the benefit of the priority of Korean Patent Application No. 10-2024-0037910, filed on March 19, 2024, which is hereby incorporated by reference in its entirety.

### TECHNICAL FIELD

An embodiment disclosed in this document relates to a battery diagnosis device and operating method thereof.

### BACKGROUND ART

Recently, research and development on secondary batteries have been actively conducted. Here, secondary batteries are batteries that can be charged and discharged, and include both conventional Ni/Cd batteries, Ni/MH batteries, and recent lithium ion batteries. Among secondary batteries, lithium ion batteries have the advantage of having much higher energy density than conventional Ni/Cd batteries, Ni/MH batteries, etc. In addition, lithium ion batteries may be manufactured to be small and lightweight, and thus the lithium ion batteries are used as a power source for mobile devices. Recently, the scope of use of the lithium ion batteries has expanded to include a power source for electric vehicles, and the lithium ion batteries are attracting attention as a next-generation energy storage medium.

There are various methods for predicting a degree of degradation of such secondary batteries in order to maintain and manage the performance of the secondary batteries. In particular, an open circuit voltage profile may be used to predict the degree of degradation of the secondary batteries during operation of the secondary batteries.

### DISCLOSURE OF THE INVENTION

### TECHNICAL PROBLEM

An objective of the embodiments disclosed in this document is to provide a battery diagnosis device that predicts a degree of degradation of a battery cell by predicting an open circuit voltage profile of the battery cell and an operating method thereof.

The technical problems of the embodiments disclosed in this document are not limited to the technical problems mentioned above, and other technical problems not mentioned can be clearly understood by those skilled in the art to which the present invention belongs from the description below.

### TECHNICAL SOLUTION

A battery diagnosis device according to an embodiment disclosed in this document may include an interface that acquires a first charge profile in the middle of life (MOL) of a battery cell, and at least one processor that predicts a second charge profile using a battery physical model representing a state of a battery and an input parameter that depends on a change in a degradation indicator corresponding to the first charge profile and calculates the degradation indicator of the battery cell corresponding to each of the first charge profile and the second charge profile

According to an embodiment, the processor may calculate the degradation indicator corresponding to each of the first charge profile and the second charge profile using a Markov Chain-Monte Carlo (MCMC) algorithm.

According to an embodiment, the degradation indicator may include a loss of lithium inventory (LLI) distribution, which is a parameter related to lithium loss in the MOL compared to the beginning of life (BOL) of the battery cell, and a loss of active material (LAM) distribution, which is a parameter related to active material loss in the MOL compared to the BOL at a negative electrode of the battery cell.

According to an embodiment, the processor may predict the degree of degradation of the battery cell based on the LLI distribution and the LAM distribution of the battery cell, and predict the degree of degradation of the battery cell based on an average value or a mode value of each of the LLI distribution and the LAM distribution.

According to an embodiment, the battery physical model may include a pseudo-two-dimensional (P2D) model.

According to an embodiment, the processor may calculate the degradation indicator until an error between the second charge profile and a premeasured open circuit voltage (OCV) profile of the battery cell reaches a threshold value.

According to an embodiment, the first charge profile and the second charge profile may include data representing a change in voltage of the battery cell over time.

According to an embodiment, the first charge profile may correspond to a change in voltage of the battery cell measured based on a charge current of the battery cell in the MOL, and the second charge profile may correspond to a change in voltage of the battery cell in an open circuit state predicted by inputting the first charge profile into the battery physical model.

A battery diagnosis device according to an embodiment disclosed in this document may include acquiring a first charge profile in the middle of life (MOL) of a battery cell, calculating a first degradation indicator of the battery cell corresponding to the first charge profile, predicting a second charge profile of the battery cell depending on a change in the first degradation indicator on a battery physical model representing a state of a battery, and calculating a second degradation indicator of the battery cell corresponding to the second charge profile.

According to an embodiment, the calculating of the first degradation indicator and the calculating of the second degradation indicator may be performed using a Markov Chain-Monte Carlo (MCMC) algorithm.

According to an embodiment, each of the first degradation indicator and the second degradation indicator may include a loss of lithium inventory (LLI) distribution, which is a parameter related to lithium loss in the MOL compared to the beginning of life (BOL) of the battery cell, and a loss of active material (LAM) distribution, which is a parameter related to active material loss in the MOL compared to the BOL at a negative electrode of the battery cell.

The operating method of the battery diagnosis device according to an embodiment may further include predicting the degree of degradation of the battery cell based on an average value or a mode value of each of the LLI distribution and the LAM distribution in the the second degradation indicator.

According to an embodiment, the battery physical model may include a pseudo-two-dimensional (P2D) model.

According to an embodiment, the predicting of the second charge profile of the battery cell may be performed until an error between the second charge profile and a premeasured open circuit voltage (OCV) profile of the battery cell reaches a threshold value.

According to an embodiment, the first charge profile and the second charge profile may include data representing a change in voltage of the battery cell over time.

According to an embodiment, the first charge profile may correspond to a change in voltage of the battery cell measured based on a charge current of the battery cell in the MOL, and the second charge profile may correspond to a change in voltage of the battery cell in an open circuit state predicted by inputting the first charge profile into the battery physical model.

### ADVANTAGEOUS EFFECTS

According to an embodiment disclosed in the present document, the degree of degradation of the battery cell can be predicted without measuring the open circuit voltage profile of the battery cell.

The effects according to an embodiment disclosed in the present document are not limited to the effects mentioned above, and other effects not mentioned can be clearly understood by those skilled in the art according to the disclosure of the present document.

### BRIEF DESCRIPTION OF THE DRAWINGS

FIG. 1 is a diagram for describing a configuration of a battery diagnosis device according to an embodiment disclosed in this document.
FIG. 2 is a diagram for describing an operation of a battery diagnosis device according to an embodiment disclosed in this document.
FIGS. 3A to 3C are diagrams for describing a degradation indicator according to an embodiment disclosed in this document.
FIGS. 4A to 4D are diagrams for describing data generated by a battery diagnosis device according to an embodiment disclosed in this document.
FIG. 5 is a flowchart for describing an operation of a battery diagnosis device according to an embodiment disclosed in this document.
FIG. 6 is a diagram for describing a computing system equipped with a battery diagnosis device according to an embodiment disclosed in this document.

### MODE FOR CARRYING OUT THE INVENTION

Hereinafter, the embodiments disclosed in this document will be described in detail with exemplary drawings. When adding reference numerals to components of each drawing, it should be noted that the same components are given the same reference numerals as much as possible even if they are illustrated in different drawings. In addition, in describing the embodiments disclosed in this document, when it is determined that a specific description of a related known configuration or function interferes with the understanding of the embodiments disclosed in this document, the detailed description thereof will be omitted.

In describing components of the embodiments disclosed in this document, terms such as first, second, A, B, (a), (b), etc. may be used. These terms are only intended to distinguish a component from another component, and the nature, order, or sequence of the component is not limited by the term. In addition, unless otherwise defined, all terms used herein, including technical or scientific terms, have the same meaning as commonly understood by a person of ordinary skill in the technical field to which the embodiments disclosed in this document belong. Terms defined in commonly used dictionaries should be interpreted as having meanings consistent with their meaning in the context of the relevant technology, and should not be interpreted in an idealized or overly formal sense unless expressly defined in this application.

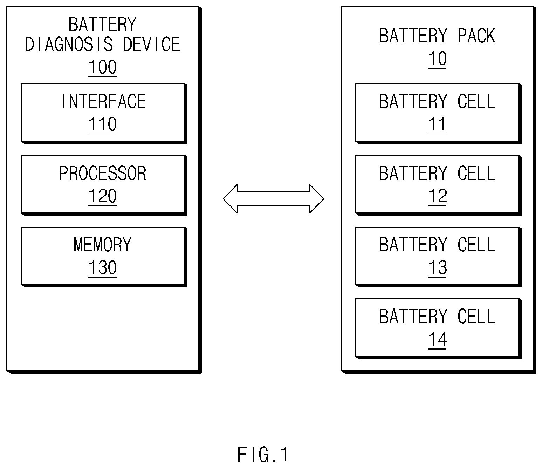

FIG. 1 is a diagram for describing a configuration of a battery diagnosis device according to an embodiment disclosed in this document.

A battery pack 10 may include a plurality of battery cells 11, 12, 13, and 14. Referring to FIG. 1, the battery pack 10 is illustrated as including four battery cells, but is not limited thereto, and the battery pack 10 may be configured to include n (n is a natural number) battery cells. In addition, the battery pack 10 may be configured to include at least one battery module (not illustrated), which is a set of at least one battery cell. Here, the plurality of battery cells 11, 12, 13, and 14 may be, lithium ion (Li-ion) batteries, nickel hydrogen (Ni-H) batteries, etc. but are not limited thereto.

The battery pack 10 may be configured to supply power to a target device (not illustrated), and to this end, the battery pack 10 may be electrically connected to the target device (not illustrated). Here, the target device (not illustrated) may include an electrical, electronic or mechanical device that operates by receiving power from the battery 10, and for example, the target device (not illustrated) may be an electric vehicle (EV) or a two-wheeled electric vehicle such as an electric scooter, etc., but is not limited thereto. In addition, when the target device is the two-wheeled electric vehicle such as the electric scooter, the battery 10 mounted on the two-wheeled electric vehicle may be replaced through a battery swapping station (BSS).

A battery diagnosis device 100 may be configured to predict a degree of degradation of the battery pack 10 and each of the plurality of battery cells 11, 12, 13, and 14 included in the battery pack 10. Referring to FIG. 1, the battery diagnosis device 100 may include an interface 110, at least one processor 120, and a memory 130.

The interface 110 may acquire a charge profile of each of the plurality of battery cells 11, 12, 13, and 14 included in the battery pack 10. Here, the charge profile may include data related to a change in voltage of each of the plurality of battery cells 11, 12, 13, and 14 over time, but is not limited thereto. The interface 110 may measure and/or predict the voltage of each of the plurality of battery cells 11, 12, 13, and 14 based on the current flowing through the battery pack 10 and/or internal resistance thereof.

According to an embodiment, the interface 110 may acquire a charge profile by applying voltage and/or current to the battery pack 10. In this case, the interface 110 may include various circuits for applying voltage and/or current to the battery pack 10 and a processor for computing and/or processing the acquired charge profile.

According to an embodiment, the interface 110 may indirectly acquire the measured charge profile from the battery pack 10. In this case, the interface 110 may further include a communication module for communicating with the battery pack 10 in a wired manner and/or wirelessly.

According to an embodiment, the interface 110 may acquire the charge profile of each of the plurality of battery cells 11, 12, 13, and 14 when a charge/discharge operation is performed on the battery pack 10. For example, the interface 110 may measure the charge/discharge current of the battery pack 10 and/or acquire data related to the change in voltage of each of the plurality of battery cells 11, 12, 13, and 14 over time based on the measured charge/discharge current.

The processor 120 may control the overall operation of the battery diagnosis device 100. Here, the processor may perform software to control at least one other component (e.g., hardware or software) of the battery diagnosis device 100, or perform operations such as processing and/or computing various data. In addition, referring to FIG. 1, the processor 120 is illustrated as one, but is not limited thereto, and the battery diagnosis device 100 may be configured to include at least one processor.

The processor 120 may calculate a degradation indicator of each of the plurality of battery cells 11, 12, 13, and 14. According to an embodiment, the processor 120 may be configured to calculate the degradation indicator of each of the plurality of battery cells 11, 12, 13, and 14 based on the charge profile of each of the plurality of battery cells 11, 12, 13, and 14.

According to an embodiment, the processor 120 may calculate the degradation indicator of each of the plurality of battery cells 11, 12, 13, and 14 based on various internal algorithms. The degradation indicator may include various indicators indicating how much each of the battery cells 11, 12, 13, and 14 has degenerated in the middle of life (MOL) compared to the beginning of life (BOL). For example, the degradation indicators may include, loss of lithium inventory (LLI), which indicates how much lithium has been lost in the MOL compared to the BOL for each of the plurality of battery cells 11, 12, 13, and 14, and loss of active material (LAM), which indicates how much active material has been lost in the MOL compared to the BOL, but are not limited thereto.

According to an embodiment, the processor 120 may calculate the degradation indicator of each of the plurality of battery cells 11, 12, 13, and 14 using a Markov Chain-Monte Carlo (MCMC) algorithm. The processor 120 may input the charge profile of each of the plurality of battery cells 11, 12, 13, and 14 acquired by the interface 110 into the MCMC algorithm to calculate the degradation indicator of each of the plurality of battery cells 11, 12, 13, and 14.

The Markov Chain-Monte Carlo (MCMC) algorithm may be an algorithm that extracts a sample having a desired static distribution by inferring a probability distribution based on the composition of a Markov Chain through Monte-Carlo simulation.

Here, the Markov chain property can express the property of a probability distribution in which a probability of a second state depends only on the probability of a first state when transitioning to the second state following the first state. For example, the weather on a particular date is not unrelated to the weather on the day before the particular date or the weather on that day. If it rained the day before a particular date, the probability of it raining on the particular date may be higher than if it did not rain the day before that particular date. As in this case, in a Markov chain state, a probability distribution when a change of state occurs can be expressed in the form of a conditional probability of the probability distribution of the previous state.

Here, Monte-Carlo may be a process of inferring infinite simulation results through finite simulation results. That is, Monte-Carlo may be a simulation method that acquires a random sample by sampling any probability distribution and probabilistically calculates a value of a function through the acquired random sample. That is, the MCMC algorithm can be defined as an algorithm that analyzes the probability distribution according to the Markov-Chain concept through the Monte-Carlo simulation.

When the MCMC algorithm is repeatedly executed, an input related to the next sample recommended by the sample generated as a result of the MCMC algorithm can be utilized as an input of the MCMC algorithm. That is, when the MCMC algorithm is repeatedly executed, the next sample recommended by the sample generated as a result of the analysis of the MCMC algorithm can be analyzed again to find an optimal sample. According to an embodiment, the processor 120 may repeatedly analyze the charge profile of each of the plurality of battery cells 11, 12, 13, and 14 acquired by the interface 110 based on the MCMC algorithm to calculate the degradation indicator of each of the plurality of battery cells 11, 12, 13, and 14.

According to an embodiment, the result of analyzing the charge profile based on the MCMC algorithm, that is, the degradation indicator of each of the plurality of battery cells 11, 12, 13, and 14, may appear in the form of a probability distribution. According to the example described above, the result of analyzing the charge profile of each of the plurality of battery cells 11, 12, 13, and 14 through the MCMC algorithm may include the LLI distribution and LAM distribution of each of the plurality of battery cells 11, 12, 13, and 14, but is not limited thereto.

Here, the distribution of the degradation indicators of each of the plurality of battery cells 11, 12, 13, and 14 analyzed through the MCMC algorithm may be different from the degree of degradation of each of the plurality of battery cells 11, 12, 13, and 14 predicted based on the open circuit voltage (OCV) of each of the plurality of battery cells 11, 12, 13, and 14 predicted through the charge profile of each of the plurality of battery cells 11, 12, 13, and 14. This is because the degree of degradation of the battery cell is relatively accurate when the battery cell is measured in an open circuit state, that is, a state in which no current flows through the battery cell, whereas the charge profile of each of the plurality of battery cells 11, 12, 13, and 14 acquired by the interface 110 is the voltage of each of the plurality of battery cells 11, 12, 13, and 14 acquired in a state in which a charge current is applied to the battery pack 10.

The processor 120 may predict and/or generate a sample, that is, a new voltage profile, recommended by the degradation indicator of each of the plurality of battery cells 11, 12, 13, and 14 calculated based on the MCMC algorithm.

According to an embodiment, the processor 120 may predict the charge profile of each of the battery cells 11, 12, 13, and 14 based on a battery physical model representing the state of a battery. There are various physical models that briefly represent the state of the battery cells 11, 12, 13, and 14 for the electrochemical analysis of the battery cells 11, 12, 13, and 14, and among the physical models, the pseudo-two-dimensional (P2D) model is a model for analyzing an electrochemical state of the battery cells 11, 12, 13, and 14 through an electrode direction and electrolyte direction of the battery cells 11, 12, 13, and 14, that is, two-dimensional analysis, and may be expressed by various equations. For example, the P2D model may be expressed by an equation that represents lithium ion current and electron movement according to an electric field in electrolyte and solid based on Ohm's Law, an equation that represent lithium ion diffusion inside active material based on Fick's Law, etc., but is not limited thereto. According to an embodiment, the battery physics model may include the pseudo-two-dimensional (P2D) model.

The processor 120 may input various input parameters into the P2D model to predict the charge profile of each of the battery cells 11, 12, 13, and 14. The meaning of predicting the charge profile of the battery cells 11, 12, 13, and 14 may correspond to the meaning of generating an equivalent battery cell that exhibits the same voltage profile as the predicted charge profile of the battery cells 11, 12, 13, and 14. That is, the processor 120 may input various input parameters into the P2D model to generate a new equivalent battery cell and acquire a predicted charge profile from the equivalent battery cell. Here, in order to generate the equivalent battery cell, a unique parameter of each of the battery cells 11, 12, 13, and 14 and a degradation parameter reflecting the degree of degradation of each of the battery cells 11, 12, 13, and 14 may be required.

The processor 120 may generate an input parameter for generating an equivalent battery cell based on the degradation indicator of each of the plurality of battery cells 11, 12, 13, and 14. The processor 120 may generate the degradation parameter described above based on the degradation indicator of each of the plurality of battery cells 11, 12, 13, and 14, and may input the generated degradation parameter and the unique parameter of each of the plurality of battery cells 11, 12, 13, and 14 into the P2D model to generate the equivalent battery cell. Here, the degradation parameter may be a dependent variable that depends on the change in the degradation indicator of each of the plurality of battery cells 11, 12, 13, and 14, but is not limited thereto.

According to an embodiment, the degradation indicator of each of the plurality of battery cells 11, 12, 13, and 14 calculated by the processor 120 may include the distribution of LLI and LAM of each of the plurality of battery cells 11, 12, 13, and 14. The processor 120 may use an average value and/or mode value of the distribution of LLI and LAM of each of the plurality of battery cells 11, 12, 13, and 14 to generate the degradation parameters based on the distribution of LLI and LAM of each of the plurality of battery cells 11, 12, 13, and 14, but is not limited thereto.

According to an embodiment, the processor 120 may produce a new degradation indicator based on the predicted charge profile of the equivalent battery cell. That is, the processor 120 may calculate the new degradation indicator (the LLI distribution and LAM distribution) by analyzing the charge profile of the equivalent battery cell through the MCMC algorithm.

The processor 120 may predict the degree of degradation of each of the plurality of battery cells 11, 12, 13, and 14. According to an embodiment, the processor 120 may predict the degree of degradation of each of the plurality of battery cells 11, 12, 13, and 14 based on the degradation indicators calculated based on a critical charge profile. For example, the processor 120 may predict the degree of degradation of each of the plurality of battery cells 11, 12, 13, and 14 based on the average value and/or mode value of the LLI distribution and the LAM distribution, etc. of each of the plurality of battery cells 11, 12, 13, and 14 calculated based on the critical charge profile, but is not limited thereto.

According to an embodiment, the processor 120 may predict the degree of degradation of each of the plurality of battery cells 11, 12, 13, and 14 based on a degree of shift and shrink predicted based on the average value and/or mode value of the LLI distribution and LAM distribution of each of the plurality of battery cells calculated based on the critical charge profile. Here, the shrink may be related to a phenomenon in which a capacity axis of the voltage profile is reduced when loss of active material occurs due to causes such as being affected by the degree of disorder of a crystal structure inside the plurality of batteries 11, 12, 13, and 14 and/or destruction or loss of particles of a negative electrode and positive electrode of the plurality of batteries 11, 12, 13, and 14. The shift may be related to a phenomenon in which the capacity axis of the voltage profile of each of the plurality of batteries 11, 12, 13, and 14 translates in a positive direction when the loss of lithium inventory (LLI) occurs due to a phenomenon such as thickening of a solid electrolyte interphase (SEI) layer formed on a surface of a negative electrode of the plurality of batteries 11, 12, 13, and 14, decomposition of an electrolyte, or lithium plating, which consumes lithium ions.

The memory 130 may store various data (e.g., instructions, parameters, charge profiles, algorithms, etc.) for the operation of the battery diagnosis device 100. According to an embodiment, the memory 130 may include a volatile memory device such as a static random access memory (SRAM) or a dynamic random access memory (DRAM), or a nonvolatile memory device such as a read only memory (ROM), a programmable ROM (PROM), or a flash memory, but is not limited thereto.

According to an embodiment, the battery diagnosis device 100 may be formed integrally with the battery pack 10. In this case, the battery diagnosis device 100 may be configured to be included in a battery management system (BMS) that controls the battery pack 10.

According to an embodiment, the battery diagnosis device 100 may be formed separately from the battery pack 10. In this case, the battery diagnosis device 100 may be connected to the battery pack 10 via a wired and/or wireless network, etc., and the battery diagnosis device 100 may be implemented in various devices such as a cloud server, a charger, or a charger/discharger.

According to an embodiment, the battery diagnosis device 100 may transmit the degradation indicator, predicted degree of degradation, etc. of each of the plurality of battery cells 11, 12, 13, and 14 to an external device (e.g., a cloud server or a user terminal). The cloud server may be configured to provide the degrees of degradation of the plurality of battery cells 11, 12, 13, and 14 to a plurality of users, and the user terminal may include a terminal such as a personal computer (PC) or a smartphone.

According to an embodiment, the battery diagnosis device 100 may be included in a battery swapping system (BSS). Here, the BSS may be a system that has a slot into which the battery pack 10 may be inserted and is capable of charging the inserted battery pack 10.

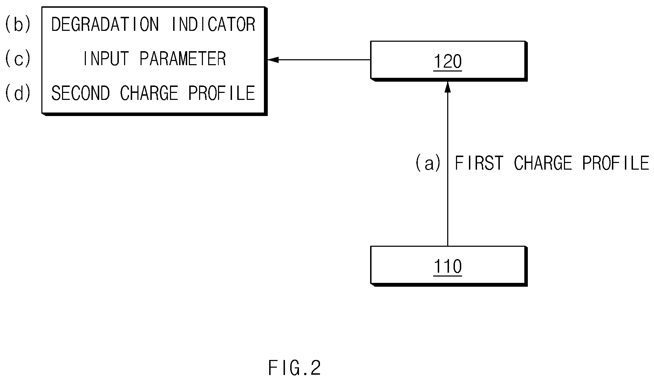

FIG. 2 is a diagram for describing the operation of the battery diagnosis device according to an embodiment disclosed in this document.

As described above in the description of FIG. 1, the interface 110 (see FIG. 1) may directly or indirectly acquire the charge profile of each of the plurality of battery cells 11, 12, 13, and 14 (see FIG. 1) (a). Here, the charge profile acquired by the interface 110 may include data related to a change in voltage of each of the plurality of battery cells 11, 12, 13, and 14 measured while the charging current flows through the plurality of battery cells 11, 12, 13, and 14 over time. Hereinafter, the charge profile acquired by the interface 110 is collectively referred to as a first charge profile.

The processor 120 (see FIG. 1) may calculate the degradation indicator of each of the plurality of battery cells 11, 12, 13, and 14 based on the first charge profile (b). According to an embodiment, the processor 120 may calculate the degradation indicator corresponding to the first charge profile of each of the plurality of battery cells 11, 12, 13, and 14 using the Markov Chain-Monte Carlo (MCMC) algorithm. Here, the degradation indicator of each of the plurality of battery cells 11, 12, 13, and 14 may include the loss of lithium inventory (LLI), which is a parameter related to the lithium loss in the MOL compared to the BOL, and the loss of active material (LAM), which is a parameter related to active material loss in the MOL compared to the BOL, but is not limited thereto.

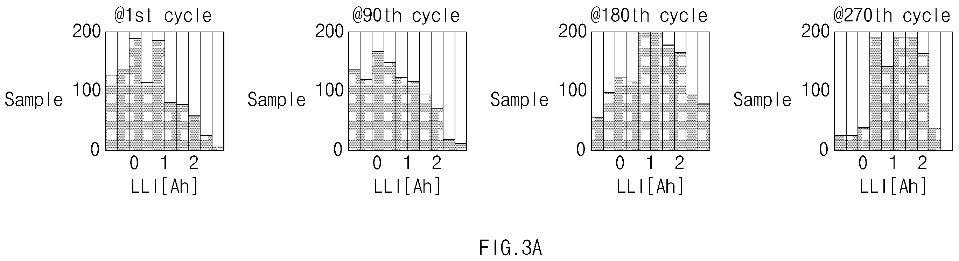

According to an embodiment, the degradation indicator of each of the plurality of battery cells 11, 12, 13, and 14 calculated using the MCMC algorithm may appear in the form of a distribution rather than a specific value. Specific details related to this will be described below in the description of FIGS. 3A to 3C.

The processor 120 may generate an input parameter to be input into the battery physical model representing the state of the battery (c). Here, the input parameter may be a parameter that depends on a change in the degradation indicator of each of the plurality of battery cells 11, 12, 13, and 14 calculated using the MCMC algorithm. According to an embodiment, the processor 120 may generate the input parameter based on the average value or mode value of the LLI distribution and LAM distribution of each of the plurality of battery cells 11, 12, 13, and 14, but is not limited thereto. In addition, the input parameter generated by the processor 120 is not limited to the specific parameter, and various parameters for being input into the P2D model described with reference to FIG. 1 may be calculated based on the degradation indicator of each of the plurality of battery cells 11, 12, 13, and 14.

The processor 120 may input the generated the input parameter into the battery physical model representing the state of the battery to predict the charging profile (d). As described above in the description of FIG. 1, the battery physical model may include a pseudo-two-dimensional (P2D) model, but is not limited thereto. That is, the processor 120 may generate an equivalent battery cell corresponding to the input parameter using the battery physical model, and generate a voltage profile predicted from the generated equivalent battery cell. Hereinafter, the voltage profile predicted from the equivalent battery cell is collectively referred to as a second charge profile.

The processor 120 may calculate an error between the second charge profile and the open circuit voltage (OCV) profile according to the experimental results of each of the plurality of battery cells 11, 12, 13, and 14 stored in advance. Here, the error (e.g., RME, RMSE, MAPE, etc. between the second charge profile and the open circuit voltage profile) may be calculated by various methods, and is not limited to a specific example.

According to an embodiment, the processor 120 may calculate a new degradation indicator corresponding to each equivalent battery cell based on the second charge profile. The processor 120 may generate an input parameter based on the new degradation indicator corresponding to each equivalent battery cell, and input the generated input parameter into the battery physical model to predict a voltage profile corresponding to the new equivalent battery cell.

This feedback process may be repeated until the error (e.g., RME, RMSE, MAPE, etc.) between the charge profile of the equivalent battery cell and the open circuit voltage profile according to the degree of degradation measured through the experimental results of each of the plurality of battery cells 11, 12, 13, and 14 stored in advance reaches a preset threshold value. Here, the preset threshold value is not limited to a specific value and may be variously set and changed. In addition, the feedback process described above may be repeated for a preset threshold number of times, and the threshold number of times here is also not limited to a specific value and may be variously set and changed.

According to an embodiment, a charge profile in a state where the error between the open circuit voltage profile and the charge profile reaches the preset threshold value, that is, the critical charge profile may correspond to an open circuit voltage profile that reflects the degree of degradation of each of the plurality of battery cells 11, 12, 13, and 14 predicted based on the P2D model and MCMC algorithm described above. That is, the battery diagnosis device 100 according to an embodiment disclosed in this document may predict an open circuit voltage profile with higher accuracy even in a state where a charging current flows through each of the plurality of battery cells 11, 12, 13, and 14.

FIGS. 3A to 3C are diagrams for describing a degradation indicator according to an embodiment disclosed in this document.

Referring to FIGS. 3A to 3C, examples of degradation indicators of the plurality of battery cells 11, 12, 13, and 14 (see FIG. 1) generated by the processor 120 (see FIG. 1) are illustrated. The graphs illustrated in FIGS. 3A to 3C are arbitrary measurement values, and the embodiments disclosed in this document are not limited to these examples.

The processor 120 may calculate a degradation indicator corresponding to each of the plurality of battery cells 11, 12, 13, and 14 and an equivalent battery cell generated by the battery physical model. According to an embodiment, the processor 120 may calculate a degradation indicator corresponding to the charge profile of each of the plurality of battery cells 11, 12, 13, and 14 and the equivalent battery cell generated by the battery physical model using the Markov Chain-Monte Carlo (MCMC) algorithm.

According to an embodiment, the degradation indicator may include the loss of lithium inventory (LLI), which is a parameter related to lithium loss in the MOL compared to the beginning of life (BOL) and the battery physical model, and the loss of active material (LAM), which is a parameter related to active material loss in the MOL compared to the BOL of each of the plurality of battery cells 11, 12, 13, and 14.

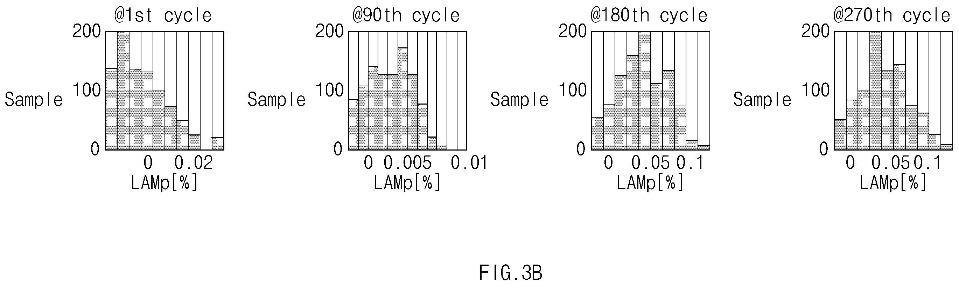

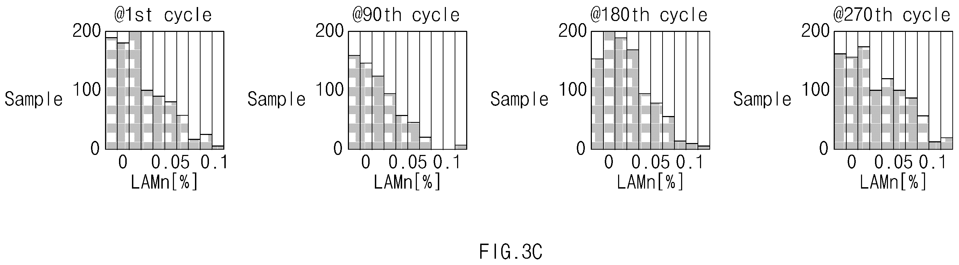

According to an embodiment, the degradation indicator may be may appear in the form of a distribution rather than a specific value. Referring to FIGS. 3A to 3C, as examples of the degradation indicators, the LLI distribution of an arbitrary battery cell (FIG. 3A), the LAM distribution of the positive electrode of an arbitrary battery cell (FIG. 3B), and the LAM distribution of the negative electrode of an arbitrary battery cell (FIG. 3C) are illustrated.

First, referring to the LLI distribution of the arbitrary battery cell illustrated in FIG. 3A, the horizontal axis represents a degree of lithium loss (LLI[Ah]), and the vertical axis represents the number of samples (Sample). That is, the degradation indicator calculated by inputting the charge profile into the MCMC algorithm appears in the form of the distribution that represents the degree of lithium loss and the number of samples corresponding to the degree of lithium loss.

As any battery cell operates in a mounting environment, charge and discharge cycles are repeated. In the LLI distribution illustrated in FIG. 3A, the number of charge/discharge cycles (1, 90, 180, and 270) gradually increases as it progresses to the right, and there is a tendency that, as the number of charge/discharge cycles increases, the battery cell degrades and the degree of lithium loss increases.

According to an embodiment, the processor 120 may generate an input parameter based on an average value or mode value of the LLI distribution illustrated in FIG. 3A. For example, when generating the input parameter based on the mode value, the processor 120 may determine 0, which is the mode value of the LLI distribution when the number of charge and discharge cycles is 90, as the LLI value, and determine 1, which is the mode value of the LLI distribution when the number of charge and discharge cycles is 180, as the LLI value. However, these are exemplary, and the embodiments disclosed in this document are not limited to these examples.

Similarly, when examining the LAM distribution in each of the positive electrode and negative electrode of an arbitrary battery cell illustrated in FIG. 3B and FIG. 3C, the horizontal axis represents a degree of active material loss LAMp,n[%], and the vertical axis represents the number of samples Sample.

As an arbitrary battery cell is operated in a mounting environment, the charge/discharge cycle is repeated. In the LAM distribution illustrated in FIGS. 3B and 3C, the number of charge/discharge cycles (1, 90, 180, 270) gradually increases as it progresses to the right, and there is a tendency that, as the number of charge/discharge cycles increases, the battery cell degrades and the degree of active material loss increases. The processor 120 may generate the input parameter based on an average value or mode value of the LLM distribution illustrated in FIGS. 3B and 3C.

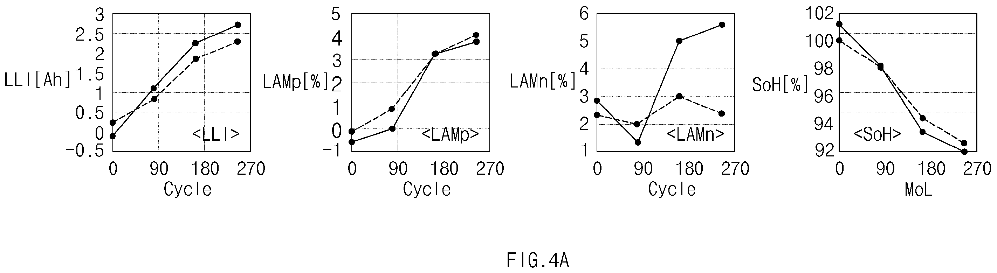

FIGS. 4A to 4D are diagrams for describing data generated by a battery diagnosis device according to an embodiment disclosed in this document.

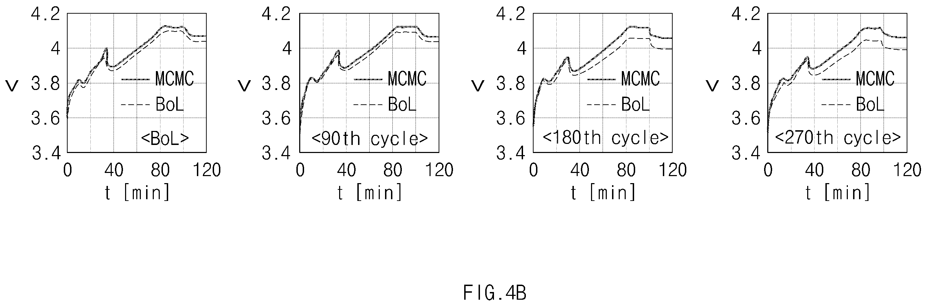

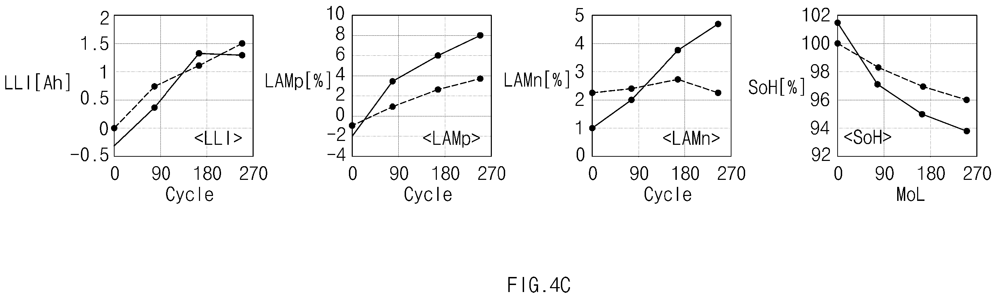

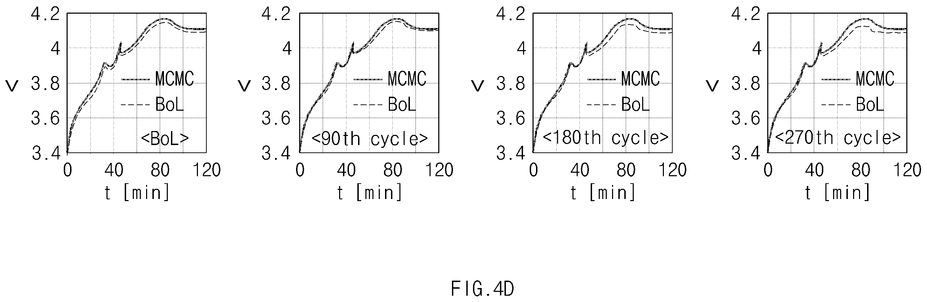

Referring to FIGS. 4A and 4B, the degradation indicators and open circuit voltages of the battery cell estimated using the charge profile at 10 degrees are illustrated, and referring to FIGS. 4C and 4D, the degradation indicators and open circuit voltages of the battery cell estimated using the charge profile at 45 degrees are illustrated.

According to an embodiment, in the plurality of graphs illustrated in each of FIGS. 4A and 4C, the dotted line graphs may correspond to graphs representing the degradation indicators of the battery cell calculated according to the embodiment disclosed in this document, and the solid line graphs may correspond to graphs representing the degradation indicators calculated based on any conventional method other than the embodiment disclosed in this document.

The degree of degradation of each of the plurality of battery cells 11, 12, 13, and 14 (see FIG. 1) calculated by the battery diagnosis device 100 (see FIG. 1) according to an embodiment disclosed in this document may be predicted. Here, the degree of degradation may include the degree of lithium loss (LLI), degree of active material loss(LAMp) at the positive electrode, degree of active material loss at the the negative electrode (LAMn), and state of health (SOH) of each battery cell.

First, referring to FIG. 4A, when examining the LLI and LAM distributions estimated using the charge profile at 10 degrees, there is a tendency that they follow the LLI and LAM distributions of the battery cell estimated based on the conventional method. The degree of active material loss (LAMn) at the negative electrode differs from the value estimated based on the conventional method. This is because the degree of active material loss (LAMn) at the negative electrode can be more accurately predicted when it is measured during a discharge process of the battery cell. Since the battery diagnosis device 100 calculates the LLI and LAM values based on the charge profile when the charging current flows through the battery cells 11, 12, 13, and 14, the results as above are derived.

In addition, referring to FIG. 4B, when examining the open circuit voltage of each of the battery cells 11, 12, 13, and 14 estimated using the charge profile at 10 degrees, it can be confirmed that the open circuit voltage (OCV) of each of the plurality of battery cells 11, 12, 13, and 14 in the MOL predicted based on the MCMC algorithm does not have a large error from the open circuit voltage value of each of the battery cells 11, 12, 13, and 14 in the BOL. The tendency described above also applies to the case where the open circuit voltage (OCV) is estimated using the charge profile at 45 degrees (FIG. 4C and FIG. 4D). Here, since the result of the MCMC algorithm may appear in the form of the distribution as described above in the description of FIGS. 1 and 3, the predicted open circuit voltage profiles of the plurality of battery cells 11, 12, 13, and 14 in the MOL based on this distribution may also be illustrated in the form of a probability distribution. According to an embodiment, shaded portions illustrated in FIG. 4B and FIG. 4D may correspond to a confidence interval having a 95% confidence level of the open circuit voltage of each of the plurality of battery cells 11, 12, 13, and 14 predicted based on the MCMC algorithm, but are not limited thereto.

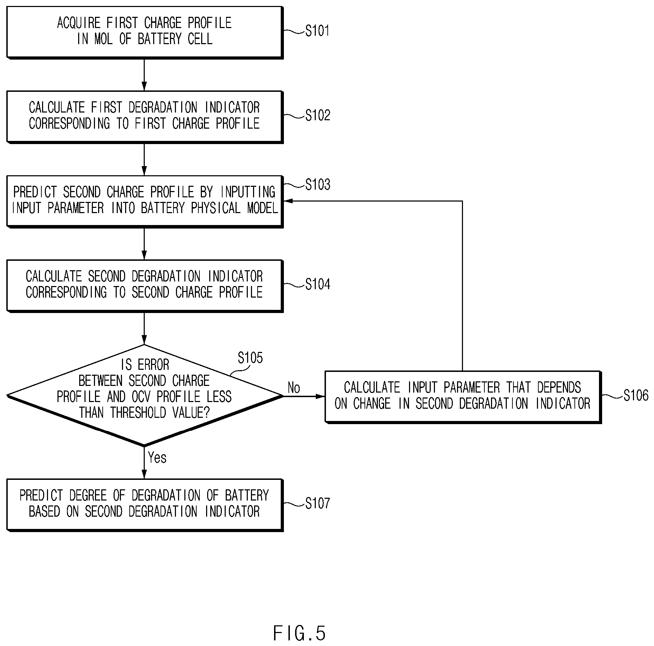

FIG. 5 is a flowchart for describing the operation of the battery diagnosis device according to an embodiment disclosed in this document.

In step S101, the battery diagnosis device 100 may acquire a first charge profile in the middle of life (MOL) of each of the plurality of battery cells 11, 12, 13, and 14. According to an embodiment, the first charge profile acquired by the battery diagnosis device 100 may include data related to a change in voltage of each of the plurality of battery cells 11, 12, 13, and 14 over time measured while charging current flows through the plurality of battery cells 11, 12, 13, and 14.

In step S102, the battery diagnosis device 100 may calculate a first degradation indicator corresponding to the first charge profile. According to an embodiment, the first degradation indicator may include a loss of lithium inventory (an LLI) indicator related to lithium loss the in the MOL compared to the beginning of life (BOL) and a loss of active material (LAM) indicator related to active material loss in the MOL compared to the BOL of each of the plurality of battery cells 11, 12, 13, and 14.

According to an embodiment, the battery diagnosis device 100 may calculate the first degradation indicator based on the Markov Chain-Monte Carlo (MCMC) algorithm. Here, the MCMC algorithm may be an algorithm that extracts a sample having a desired static distribution by inferring a probability distribution based on the composition of a Markov Chain through Monte-Carlo simulation.

According to an embodiment, the first degradation indicator calculated based on the MCMC algorithm may appear in the form of a distribution rather than a specific value. For example, the battery diagnosis device 100 may calculate the first degradation indicator, that is, the LLI distribution and the LAM distribution of each of the plurality of battery cells 11, 12, 13, and 14, using the MCMC algorithm.

In step S103, the battery diagnosis device 100 may predict a second charge profile by inputting an input parameter into the battery physical model. According to an embodiment, the battery physical model may include the pseudo-two-dimensional (P2D) model as a physical model representing the state of a battery, but is not limited thereto.

According to an embodiment, the battery diagnosis device 100 may generate an input parameter to be input into a battery physical model. Here, the input parameter may be a dependent variable that depends on a change in the first degradation indicator calculated by the battery diagnosis device 100, and may correspond to various variables input into the battery physical model to interpret the state of the battery.

In step S104, the battery diagnosis device 100 may calculate a second degradation indicator corresponding to the second charge profile. According to an embodiment, the battery diagnosis device 100 may calculate the second degradation indicator corresponding to the second charge profile based on the second charge profile and the MCMC algorithm, and the second degradation indicator may also appear in the form of the distribution.

In step S105, the battery diagnosis device 100 may determine whether an error between the second charge profile and the open circuit voltage (OCV) profile of each of the plurality battery cells 11, 12, 13, and 14 stored in advance is less than a preset threshold value. Here, the error (e.g., RMSE, RME, MAPE, etc.) may be calculated based on various methods, and a threshold value is also not limited to a specific value.

According to an embodiment, when the error between the second charge profile and the open circuit voltage profile stored in advance is greater than or equal to the threshold value (N), the battery diagnosis device 100 may calculate the second degradation indicator corresponding to the second charge profile and calculate an input parameter that depends on a change in the second degradation indicator (S106). Here, the battery diagnosis device 100 may calculate the second degradation indicator based on the MCMC algorithm. Thereafter, the battery diagnosis device 100 may repeat steps S103 to S106 until the error between the predicted charge profile and the open circuit voltage profile stored in advance becomes less than the threshold value.

According to an embodiment, when the error between the second charge profile and the open circuit voltage profile stored in advance is less than the threshold value (N), the battery diagnosis device 100 may predict the degree of degradation of each of the plurality of battery cells 11, 12, 13, and 14 based on the second degradation indicator. For example, the battery diagnosis device 100 may predict the degree of degradation of each of the plurality of battery cells 11, 12, 13, and 14 based on the degree of shift and shrink predicted based on an average value and/or mode value of the LLI distribution and LAM distribution of each of the plurality of battery cells calculated based on the second charge profile, but is not limited thereto.

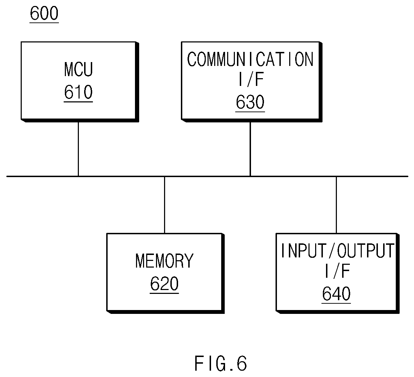

FIG. 6 is a diagram for describing a computing system equipped with a battery diagnosis device according to an embodiment disclosed in this document.

Referring to FIG. 6, a computing system 600 may include an MCU 610, a memory 620, an input/output I/F 630, and a communication I/F 640.

The MCU 610 may be a processor that executes various programs (e.g., battery cell inspection programs, battery cell degradation prediction programs, etc.) stored in the memory 620, processes various data for predicting the degree of degradation of each of the plurality of battery cells 11, 12, 13, and 14 (see FIG. 1) through these programs, and performs the functions of the battery diagnosis device 100 described with reference to FIG. 1.

The memory 620 may store various programs for predicting the degree of degradation of the battery cell. In addition, the memory 620 may store information on the open circuit voltage (OCV) profile stored in advance.

A plurality of such memories 620 may be provided as needed. The memory 620 may be a volatile memory or a nonvolatile memory. The memory 620 as the volatile memory, RAM, DRAM, SRAM, etc. may be used. The memory 620 as the nonvolatile memory, ROM, PROM, EAROM, EPROM, EEPROM, flash memory, etc. may be used. The examples of the memories 620 listed above are only examples and are not limited to these examples.

The input/output I/F 630 may provide an interface that connects an input device (not illustrated) such as a keyboard, mouse, or touch panel and an output device such as a display (not illustrated) with the MCU 610 to transmit and receive data.

The communication I/F 640 may be a configuration that can transmit and receive various data to ad from a server, and may be various devices that can support wired or wireless communication. For example, a program or various data for predicting the degree of degradation of a battery cell may be transmitted and received to and from a separately provided external server through the communication I/F 640.

In this way, the battery management method according to an embodiment disclosed in this document may be recorded in the memory 620 and executed by the MCU 610.

In the above, all components constituting the embodiment have been described as being combined or operated by being combined as one, but is not necessarily limited to this embodiment, and within the scope of the purpose, all components may be operated by being selectively combined as one or more. In addition, the terms "include," "configure," or "have" described above, unless specifically stated to the contrary, mean that the corresponding component can be inherent, and therefore should be interpreted as being able to include other components rather than excluding other components.

The above description is merely an example of the technical idea disclosed in this document, and those with ordinary skill in the technical field to which the embodiments disclosed in this document belong may make various modifications and variations without departing from the essential characteristics of the embodiments disclosed in this document.

Therefore, the embodiments disclosed in this document are not intended to limit the technical idea disclosed in this document, but rather to explain them, and the scope of the technical idea disclosed in this document is not limited by these embodiments. The scope of protection of the technical idea disclosed in this document should be interpreted by the claims below, and all technical ideas within the scope equivalent to the claims should be interpreted as being included in the scope of rights of this document.

### [Description of reference numerals]

- 10:: battery pack
- 11, 12, 13, 14:: battery cell
- 100:: battery diagnosis device
- 110:: interface
- 120:: processor
- 130:: memory

## Claims

1. A battery diagnosis device comprising:
an interface that acquires a first charge profile in the middle of life (MOL) of a battery cell; and
at least one processor that predicts a second charge profile using a battery physical model representing a state of a battery and an input parameter that depends on a change in a degradation indicator corresponding to the first charge profile and calculates the degradation indicator of the battery cell corresponding to each of the first charge profile and the second charge profile.

2. The battery diagnosis device of claim 1, wherein the processor calculates the degradation indicator corresponding to each of the first charge profile and the second charge profile using a Markov Chain-Monte Carlo (MCMC) algorithm.

3. The battery diagnosis device of claim 2, wherein the degradation indicator includes a loss of lithium inventory (LLI) distribution, which is a parameter related to lithium loss in the MOL compared to the beginning of life (BOL) of the battery cell, and a loss of active material (LAM) distribution, which is a parameter related to active material loss in the MOL compared to the BOL at a negative electrode of the battery cell.

4. The battery diagnosis device of claim 3, wherein the processor predicts the degree of degradation of the battery cell based on the LLI distribution and the LAM distribution of the battery cell, and predicts the degree of degradation of the battery cell based on an average value or a mode value of each of the LLI distribution and the LAM distribution.

5. The battery diagnosis device of claim 1, wherein the battery physical model includes a pseudo-two-dimensional (P2D) model.

6. The battery diagnosis device of claim 5, wherein the processor calculates the degradation indicator until an error between the second charge profile and a premeasured open circuit voltage (OCV) profile of the battery cell reaches a threshold value.

7. The battery diagnosis device of claim 1, wherein the first charge profile and the second charge profile include data representing a change in voltage of the battery cell over time.

8. The battery diagnosis device of claim 7, wherein the first charge profile corresponds to a change in voltage of the battery cell measured based on a charge current of the battery cell in the MOL, and
the second charge profile corresponds to a change in voltage of the battery cell in an open circuit state predicted by inputting the first charge profile into the battery physical model.

9. An operating method of a battery diagnosis device, comprising:
acquiring a first charge profile in the middle of life (MOL) of a battery cell;
calculating a first degradation indicator of the battery cell corresponding to the first charge profile;
predicting a second charge profile of the battery cell depending on a change in the first degradation indicator on a battery physical model representing a state of a battery; and
calculating a second degradation indicator of the battery cell corresponding to the second charge profile.

10. The operating method of claim 9, wherein the calculating of the first degradation indicator and the calculating of the second degradation indicator are performed using a Markov Chain-Monte Carlo (MCMC) algorithm.

11. The operating method of claim 10, wherein each of the first degradation indicator and the second degradation indicator includes a loss of lithium inventory (LLI) distribution, which is a parameter related to lithium loss in the MOL compared to the beginning of life (BOL) of the battery cell, and a loss of active material (LAM) distribution, which is a parameter related to active material loss in the MOL compared to the BOL at a negative electrode of the battery cell.

12. The operating method of claim 11, further comprising:
predicting the degree of degradation of the battery cell based on an average value or a mode value of each of the LLI distribution and the LAM distribution included in the the second degradation indicator.

13. The operating method of claim 9, wherein the battery physical model includes a pseudo-two-dimensional (P2D) model.

14. The operating method of claim 13, wherein the predicting of the second charge profile of the battery cell is performed until an error between the second charge profile and a premeasured open circuit voltage (OCV) profile of the battery cell reaches a threshold value.

15. The operating method of claim 9, wherein the first charge profile and the second charge profile include data representing a change in voltage of the battery cell over time.

16. The operating method of claim 15, wherein the first charge profile corresponds to a change in voltage of the battery cell measured based on a charge current of the battery cell in the MOL, and
the second charge profile corresponds to a change in voltage of the battery cell in an open circuit state predicted by inputting the first charge profile into the battery physical model.
